# EUROPÄISCHE PATENTSCHRIFT

(11) **EP 1 217 450 B1**
(45) Veröffentlichungstag und Bekanntmachung des Hinweises auf die Patenterteilung: **29.09.2004**
(21) Anmeldenummer: 01130183.5
(22) Anmeldetag: 19.12.2001
(51) Int. Cl.: G03F 7/20

(54) **Lichtintegrator für eine Beleuchtungseinrichtung**
Light integrator for an irradiation device
Intégrateur de lumière pour un dispositif d illumination

(30) Priorität: 20.12.2000 DE 10065198
(43) Veröffentlichungstag der Anmeldung: 26.06.2002
(73) Patentinhaber: Carl Zeiss SMT AG, 73447 Oberkochen (DE)
(72) Erfinder: Van der Lei, Sijbe Abraham Hartman, 5501 DV Veldhoven (NL); Tas, Marnix Aldert, 5631 JL Eindhoven (NL); Hoegee, Jan, 5653 Eindhoven (NL); Van der Veen, Paul, 5611 SR Eindhoven (NL); Köhler, Jess, 73447 Oberkochen (DE); Wangler, Johannes, 89551 Königsbronn (DE)
(74) Vertreter: Patentanwälte Ruff, Wilhelm, Beier, Dauster & Partner

(56) Entgegenhaltungen:
- EP-A- 0 747 772
- EP-A- 1 170 635
- EP-A- 1 184 727
- WO-A-99/32938
- DE-A- 19 912 464
- "Diaphragm at quartz-rod entrance for I-line scanners" RESEARCH DISCLOSURE NO. 42343, Juli 1999 (1999-07), Seite 939 XP000888962
- PATENT ABSTRACTS OF JAPAN vol. 1996, no. 02, 29. Februar 1996 (1996-02-29) & JP 07 261292 A (MEJIRO PRECISION KK), 13. Oktober 1995 (1995-10-13)

## Beschreibung

Die Erfindung betrifft einen Lichtintegrator für eine Beleuchtungseinrichtung, insbesondere eine Beleuchtungseinrichtung für eine Mikrolithographie-Projektionsbelichtungsanlage, gemäß dem Oberbegriff von Anspruch 1 sowie eine mit dem Lichtintegrator ausgestattete Beleuchtungseinrichtung.

Die Leistungsfähigkeit von Projektionsbelichtungsanlagen für die mikrolithographische Herstellung von Halbleiterbauelementen wird wesentlich durch die Abbildungseigenschaften der Projektionsoptik bestimmt. Darüber hinaus wird die Bildqualität und der mit einem Wafer-Stepper oder Wafer-Scanner erzielbare Waferdurchsatz wesentlich durch Eigenschaften der dem Projektionsobjektiv vorgeschalteten Beleuchtungseinrichtung mitbestimmt. Diese muß in der Lage sein, eine möglichst große Lichtmenge bei gleichmäßiger Intensitätsverteilung in einer an die nachgeschalteten Optiksysteme genau angepassten Weise bereitzustellen.

Die Anpassung an nachfolgende Systeme wird wesentlich durch die ausgangsseitige Telezentrie der Beleuchtungseinrichtung mitbestimmt. Ein hoher Grad von Gleichmäßigkeit bzw. Homogenität der auf die Photomaske fallenden Beleuchtung kann durch Mischung des von einer Lichtquelle kommenden Lichtes in der Beleuchtungseinrichtung mit Hilfe sogenannter Lichtintegratoren bzw. Lichtmischelemente erreicht werden. Neben den mit Wabenkondensatoren arbeitenden Lichtintegratoren haben sich Lichtintegratoren durchgesetzt, die einen Stab aufweisen, der aus einem für das Licht einer Lichtquelle der Beleuchtungseinrichtung transparenten Material besteht und im wesentlichen in seiner Längsrichtung (z-Richtung) durchstrahlt wird. Der Stab wird im folgenden auch als Glasstab bezeichnet, obwohl er nicht nur aus glasartigem Material, beispielsweise synthetischem Quarzglas, sondern auch aus kristallinem Material, beispielsweise Calciumfluorid, bestehen kann. Der Stab hat eine der Lichtquelle der Beleuchtungseinrichtung optisch zugewandte Eintrittsfläche, in die das Licht der Lichtquelle einfällt, sowie eine gegenüberliegende Austrittsfläche, die eine Zwischenfeldebene der Beleuchtungseinrichtung bilden kann.

Da die Querschnittsform des Stabes der Form der zu beleuchtenden Fläche angepasst sein soll, ist der Stabquerschnitt der hier betrachteten Stäbe rechteckig mit einem vom Wert 1 abweichenden Aspektverhältnis zwischen Breite (bzw. x-Richtung) und Höhe (bzw. y-Richtung). In dem Glasstab wird das durchtretende Licht wie in einem Kaleidoskop vielfach an den lateralen Grenzflächen totalreflektiert, wodurch eine annähernd perfekte Mischung von nicht homogenen Anteilen des Lichtes erzielbar ist. Daher wird die Austrittsfläche des Stabes als ein praktisch gleichförmig beleuchtetes Feld auf die Photomaske abgebildet. Beleuchtungseinrichtungen, die derartige rechteckige Stäbe als Lichtintegrator nutzen, sind beispielsweise in der DE 44 21 053, der DE 195 20 363 oder der DE 199 12 464 offenbart.

Es ist erkannt worden, daß die Verteilung der Lichtenergie am Ausgang derartiger stabförmiger Lichtintegratoren im Winkelraum eine unerwünschte Asymmetrie aufweist. Diese Asymmetrie wird im folgenden als (energetische) Elliptizität der Pupille bezeichnet und kann für jeden Bildort bzw. Punkt (x, y) der Austrittsfläche des Stabes beschrieben werden. Der Beschreibung der Elliptizität liegt die Überlegung zugrunde, daß von jedem Bildort Lichtenergie über eine bestimmte Winkelverteilung abgegeben wird, also nicht nur in z-Richtung (entsprechend der Längsrichtung des Stabes) sondern auch mit Komponenten quer zur z-Richtung. Während idealerweise innerhalb der Winkelverteilung die Energiedichte für alle Richtungen gleich sein sollte, wird in realen Systemen eine Abweichung von der Symmetrie, also eine Deformation der Energieverteilung, beobachtet, bei der die Lichtintensität in Bereichen, die von der x-Achse weiter entfernt sind, geringer ist als in Bereichen, die ebenso weit von der y-Achse entfernt sind. Dies kann zu einer unerwünschten Ungleichförmigkeit der Ausleuchtung am Wafer führen.

In der nachveröffentlichten EP 1 170 635 A2 werden verschiedene Ursachen genannt, die innerhalb eines Beleuchtungssystems mit Stabintegrator zu einem Elliptizitätsfehler führen können. Zur Korrektion solcher Fehler wird ein optisches Element vorgeschlagen, das um die optische Achse des Beleuchtungssystems drehbar ist. Bevorzugt ist das optische Element ein diffraktives optisches Element, das als Mikrolinsen Array gestaltet sein kann. Die ebenfalls nachveröffentlichte Patentanmeldung EP 1 184 727 A1 spricht ebenfalls das Problem der Pupillenelliptizität an. Die Vorschläge zur Lösung des Problems umfassen einen statischen oder dynamischen Grautonfilter oder ein drehbares Element, wie es auch in der in der Patentanmeldung zitierten EP 1 170 635 A2 beschrieben ist.

In dem Artikel "Diaphragm at quartz-rod entrance for I-line scanners", Research Disclosure No. 42343, Juli 1999, Seite 939 wird ein Beleuchtungssystem mit einem quaderförmigen Quarzstab beschrieben, dem eine Quecksilber-Hochdrucklampe als Lichtquelle zugeordnet ist. Bei solchen Lichtquellen mit hohem Lichtleitwert besteht das Problem, dass bei gewissen Beleuchtungssettings ein Teil des von der Lichtquelle kommenden Lichts nicht in den Integratorstab eingekoppelt wird, so dass gewisse Winkelbereiche fehlen, was zu einer elliptischen Pupille führen kann. Als Lösung dieses Problems wird vorgeschlagen, am Stabeintritt eine Blende mit runder Blendenöffnung anzuordnen.

Die japanische Patentanmeldung JP 07 261 292 A zeigt ein Beleuchtungssystem für eine Belichtungsanlage, die mit einer Kurzbogen-Entladungslampe als Lichtquelle arbeitet und einen Stabintegrator zur Homogenisierung der Beleuchtung umfasst. Im Lichtweg hinter dem Stabintegrator ist eine Kondensorlinsengruppe angeordnet, die dafür ausgelegt ist, Feldaberrationen zu korrigieren.

In der internationalen Patentanmeldung WO 99/32938 ist ein Beleuchtungssystem mit einem prismatischen Integrator gezeigt. An den Grenzflächen des Integrators sind Furchen angebracht, die vorzugsweise einen Dreiecks-Querschnitt haben. Durch die Furchen an den Grenzflächen werden in der durchtretenden Strahlung zusätzliche Winkel eingeführt, wodurch die Pupille "verschmiert" und damit die Symmetrie der Pupillenausleuchtung erhöht werden soll.

Der Erfindung liegt die Aufgabe zugrunde, einen Lichtintegrator der eingangs erwähnten Art vorzuschlagen, der eine im Vergleich zu herkömmlichen Lichtintegratoren verbesserte Homogenität der Beleuchtung ermöglicht, insbesondere im Hinblick auf winkelabhängige Intensitätsinhomogenitäten.

Zur Lösung dieser Aufgabe schlägt die Erfindung einen Lichtintegrator mit den Merkmalen von Anspruch 1 bzw. eine Beleuchtungseinrichtung mit den Merkmalen von Anspruch 14 vor. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Ein erfindungsgemäßer Lichtintegrator zeichnet sich dadurch aus, dass Kompensationsmittel zur Kompensation richtungsabhängiger Totalreflexionsverluste des Stabes vorgesehen sind, wobei dem Stab als Kompensationsmittel mindestens ein im Querschnitt rechteckiger, transparenter Kompensationsabschnitt zugeordnet ist, der so ausgebildet ist, dass Totalreflexionsverluste in Breitenrichtung des Kompensationsabschnitts größer sind als in der dazu senkrechten kürzeren Höhenrichtung. Diesem Vorschlag liegt die Erkenntnis zu Grunde, dass die Reflexion von Lichtstrahlen an den breiten und schmalen lateralen Seitenflächen des Glasstabes auch bei optimal präparierten Seitenflächen nicht total, sondern unvollkommen ist. Ursache hierfür kann beispielsweise eine Rauhheit der reflektierenden Oberflächen sein, die zur Folge hat, dass Lichtstrahlen lokal nicht mehr im Winkelgebiet der Totalreflexion liegen und dementsprechend ein Teil der Lichtintensität ausgekoppelt wird. Es ist auch möglich, dass im Bereich der Glasstabsoberflächen Verunreinigungsatome in das Stabmaterial eingelagert sind mit der Folge, dass der Brechungsindex am Stabrand nicht demjenigen des Materials im Inneren entspricht. Dies kann zur Teilauskopplung von Licht beitragen. Auch Absorptionseffekte im Oberflächenbereich können die Intensität des totalreflektierten Lichts herabsetzen.

Da der Glasstab bei den hier betrachteten Lichtintegratoren konstruktiv bedingt rechteckig ist, ist die Anzahl der Reflexionen beim Lichtdurchtritt an den Seitenflächen deutlich verschieden. Dabei wird Licht, dessen Reflexionsebene im wesentlichen parallel zur breiteren Seite des Stabes ausgerichtet ist und das an den Schmalseiten reflektiert wird, im Mittel deutlich weniger häufig reflektiert als Licht, das vorwiegend in Ebenen reflektiert wird, die in Längsrichtung des Stabes im wesentlichen parallel oder im spitzen Winkel zu den Schmalseiten des Stabes, also in der Nähe der y-Richtung verlaufen. Auf Grund der bei realen Systemen unvollständigen Totalreflexion ergeben sich am Stabausgang Intensitätsverluste, deren Betrag im wesentlichen von der Anzahl der Reflexionen beim Lichtdurchtritt sowie vom Grad von Totalreflexionsverlusten pro Reflexionsvorgang abhängig ist. Dadurch ergeben sich bei weitgehend gleichen Oberflächeneigenschaften der Breit- und Schmalseiten im Winkelbereich bei großen y-Werten höhere Verluste als bei x-Werten gleicher Grösse. Eine Kompensation dieser nachteiligen Effekte, und damit eine Verminderung der Ellipzität der Pupille kann dadurch erreicht werden, dass mit Hilfe geeigneter Kompensationsmittel die Produkte aus der Anzahl von Reflexionen multipliziert mit dem Totalreflexionsverlust pro Reflexion in x-Richtung und y-Richtung aneinander angeglichen werden.

Dies kann beispielsweise dadurch erreicht werden, dass das spezifische Totalreflexionsvermögen der schmalen Seitenflächen, an denen weniger Reflexionen stattfinden, gezielt vermindert wird, so dass die Totalreflexionsverluste pro Reflexion steigen und eine Angleichung zwischen x-und y-Richtung bewirkt wird. Das spezifische Totalreflexionsvermögen kann beispielsweise dadurch vermindert werden, dass an der entsprechenden Oberfläche über einen geeignet lang gewählten Abschnitt in z-Richtung oder in mindestens einem Teilbereich geeigneter Grösse die Oberfläche aufgerauht, mit einer das Reflexionsvermögen vermindernden Beschichtung versehen, mit einem Gas umspült, mit einer Flüssigkeit benetzt und/oder gezielt mit den Brechungsindex ändernden Substanzen dotiert oder belegt wird. Hierzu kann mindestens ein Teilbereich mindestens einer Stabseitenfläche eine geeignete Beschichtung aufweisen oder eine Aufrauhung, d.h. eine gezielte Vergrösserung der Oberflächenrauhigkeit relativ zu den angrenzenden glatten Oberflächenabschnitten. Es kann auch mindestens eine Einrichtung zur Beaufschlagung mindestens eines Teilbereichs einer oder mehrerer Stabaussenflächen mit einem flüssigen oder gasförmigen Fluid vorgesehen sein, welches die Reflektivität im beaufschlagten Teilbereich verändert, insbesondere die Totalreflektivität vermindert. Die Einrichtung kann z.B. eine Gasspüleinrichtung oder eine Benetzungseinrichtung sein. Es ist auch möglich, durch geeignete Massnahmen die Anzahl der Reflexionen in der parallel zur Stabbreitseite verlaufenden x-Richtung zu erhöhen, wobei ggf. das spezifische Totalreflektionsvermögen an den Seitenflächen unverändert bleiben kann. Auch eine Kombination dieser Massnahmen ist möglich.

Durch eine oder mehrere dieser Massnahmen ist es erfindungsgemäß möglich, dem Stab mindestens einen im Querschnitt rechtwinkligen, transparenten Kompensationsabschnitt geeigneter Länge in z-Richtung zuzuordnen, der so ausgebildet ist, dass seine Totalreflexionsverluste in Breitenrichtung (parallel zur x-Richtung) grösser sind als in der dazu senkrechten Höhenrichtung (parallel zur y-Richtung). Weil dadurch im Kompensationsabschnitt bzgl. der Totalreflexionsverluste genau umgekehrte Verhältnisse herrschen wie im Stab, ist eine Kompesation der energetischen Asymmetrie am Stabausgang möglich, wobei deren Stärke durch Auslegung des Kompensationsabschnittes beeinflussbar ist.

Bevorzugt sind Varianten, bei denen ein Kompensationsabschnitt am Eingangsbereich des Lichtintegrators vorgesehen ist, wobei der Kompensationsabschnitt vorzugsweise in Lichtdurchlaufrichtung vor der Eintrittsfläche des Stabes angeordnet sein kann. Dadurch wird erreicht, dass hinter dem Kompensationsabschnitt eine große Stablänge verfügbar ist, die eine ausreichend starke Durchmischung des Lichtes ermöglicht.

Der Kompensationsabschnitt kann einstückig mit dem Glasstab ausgebildet sein, ist jedoch bevorzugt durch eine gesonderte optische Baugruppe realisiert. Dadurch ist es möglich, bereits existierende Systeme ohne aufwendige Eingriffe in den Herstellungs- und Einbauprozess der Glasstäbe in erfindungsgemäßer Weise zu modifizieren. Durch Auswechslung von Kompensationsabschnitten sind auch verschiedene Kompensationsgrade einstellbar, um beispielsweise das Integratorsystem an verschiedene Beleuchtungsmodi anzupassen.

Ein bevorzugter Lichtintegrator zeichnet sich dadurch aus, dass vor der Eintrittsfläche des Stabes mindestens eine Stabanordnung angeordnet ist, die mehrere Stäbchen aus einem für das Licht der Lichtquelle transparenten Material aufweist, wobei die Stäbchen vorzugsweise jeweils einen rechteckigen Querschnitt mit einem zum Aspektverhältnis des Stabes umgekehrten Aspektverhältnis aufweisen. Hierbei ist ein "umgekehrtes" Aspektverhältnis nicht notwendig durch den Kehrwert des Aspektverhältnisses definiert, sondern allgemein so, dass das Aspektverhältnis der Stäbchen kleiner als 1 ist, wenn das Aspektverhältnis des Stabes grösser als 1 ist oder umgekehrt. Durch eine derartige als Kompensationsabschnitt dienende Stabanordnung, bei der die Stäbchen in Bezug auf die Eintrittsfläche des Stabes vorteilhafterweise im wesentlichen querschnittsfüllend angeordnet sind, kann die eingangs erläuterte Elliptizität auf ein für die jeweilige Anwendung tolerierbares Maß reduziert oder gegebenenfalls vollständig beseitigt werden. Indem vor dem Glasstab ein Satz kleiner Stäbchen angeordnet wird, die ebenfalls rechteckig sind, deren lange Seiten aber parallel zur kurzen Seite des Stabes sind, wird erreicht, daß der Unterschied der Anzahl an Reflexionen in x- und y-Richtung verringert wird. Eine Veränderung des spezifischen Reflexionsvermögens der Oberfläche z.B. durch Beschichtung, Aufrauhung und/oder Benetzung mit einem Fluid kann zusätzlich vorgesehen sein, ist jedoch prinzipiell nicht erforderlich.

Eine vollständige Kompensation der Totalreflexionsverluste ist möglich. Sie würde bei unveränderten Oberflächeneigenschaften eine aus geometrischen Überlegungen ableitbare große Zahl an Stäbchen und/oder sehr dünne Stäbchen und/oder eine große Durchtrittslänge des Kompensationsabschnittes erfordern. In der Praxis kann jedoch eine Teilkompensation ausreichen, so daß Kompensationsabschnitte kompakt herstellbar und mit geringem Aufwand in die Einbauumgebung der Beleuchtungseinrichtung integrierbar sind. Vorzugsweise hat der Kompensationsabschnitt, insbesondere die Stabanordnung eine Länge, die mehr als 5 % der Länge des Stabes beträgt; wobei die Länge des Kompensationsabschnitts vorzugsweise mehr als 10 %, insbesondere zwischen ca. 15 % und 50 % der Länge des Stabes beträgt. Die Anzahl der Stäbchen ist zweckmäßig größer als das Aspektverhältnis des Stabquerschnittes und kann beispielsweise im Bereich zwischen 3 und 15 bis 20 Stäbchen liegen. Die Höhe der Stäbchen kann im wesentlichen derjenigen des Stabes entsprechen. Herstellungstechnisch vorteilhaft ist es, wenn die Stäbchen identische Stäbchenquerschnitte und -längen aufweisen. Es sind jedoch prinzipiell auch abweichende Dimensionen der einzelnen Stäbchen möglich. Es kann ggf. eine bessere Lichtdurchmischung erreicht werden, wenn die Stäbchen unterschiedliche Dimensionen haben. Es ist möglich, daß die Stäbchen durch dünne Platten oder Folien gebildet sind, also insbesondere durch solche transparente Elemente, bei denen das Verhältnis zwischen Breite und Höhe mehr als 100 oder sogar mehr als 1000 betragen kann.

Bei Ausführungsformen, bei denen der beispielsweise durch eine Stabanordnung gebildete Kompensationsabschnitt eine gesonderte Baugruppe darstellt, wird diese zweckmäßig so angeordnet, daß zwischen dem Kompensationsabschnitt und der Stabeintrittsfläche ein geringfügiger Abstand von beispielsweise weniger als einem Millimeter verbleibt. Dadurch können Berührungen der empfindlichen Oberflächen von Glasstab und Kompensationsabschnitt und dadurch mögliche Beschädigungen dieser Flächen verhindert werden.

Um einen möglichst großen Anteil des Stabquerschnitts für einen Lichtdurchtritt nutzen zu können, weist die Stabanordnung zweckmäßig eine dichte Packung von Stäbchen auf, wobei die Stäbchen jedoch vorzugsweise weitgehend ohne gegenseitigen Berührungskontakt mit lateralem Abstand zueinander angeordnet sein können, der beispielsweise im Bereich von weniger als 0.5 mm oder 0.3 mm liegen kann. Eine dichte Packung, bei der dennoch die einzelnen Reflexionsflächen der Stäbchen weitgehend frei liegen, kann durch geeignete zwischengelegte Abstandhalter, z.B. Folien, sichergestellt werden, die zweckmäßig aus einem Material bestehen, durch das die Totalreflexion in ihrem jeweiligen Abstützbereich an den benachbarten Stäbchen nicht beeinflußt wird.

In der Regel ist es ausreichend, wenn der Reflexionsgrad der einander zugewandten Flächen zwischen den Stäbchen größer als 50% ist, wobei mindestens 75% besonders bevorzugt sind. Eine praktisch vollständige Totalreflexion ist hier nicht erforderlich. Ein dichte Packung mit Abstandhaltern erleichtert das Handling der Stabanordnung und stellt eine Parallelität der Stäbchen bei der Fassung der Anordnung und im Betrieb sicher. Gleichzeitig sind die einzelnen Stäbchen optisch derart gut von einander entkoppelt, daß die Totalreflexion weitgehend erhalten bleibt. Durch Einstellung geeigneter Reflexionsgrade zwischen den Stäbchen kann ein gewünschter Grad von Durchmischung im Bereich der Stabanordnung eingestellt werden.

Die vorstehenden und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können. Hierbei zeigen:
- Fig. 1: eine schematische Darstellung einer bevorzugten Ausführungsform einer erfindungsgemäßen Beleuchtungseinrichtung;
- Fig. 2: eine Draufsicht auf die Breitseite einer Ausführungsform eines erfindungsgemäßen Lichtintegrators mit schematischer Darstellung von Reflexionen in Breitenrichtung und
- Fig. 3: eine Seitenansicht des in Figur 2 gezeigten Lichtintegrators mit Reflexionen in Höhenrichtung;
- Fig. 4: ein schematisches Diagramm zur Erläuterung der Definition der energetischen Elliptizität an der Austrittsfläche des Lichtintegrators;
- Fig. 5: ein schematisches Diagramm einer Elliptizitätsverteilung am Austritt eines konventionellen, stabförmigen Lichtintegrators;
- Fig. 6: ein Diagramm, das die Elliptizität der Pupille als Funktion des Ortes entlang der x-Richtung für einen konventionellen und eine erfindungsgemäßen Lichtintegrator zeigt.

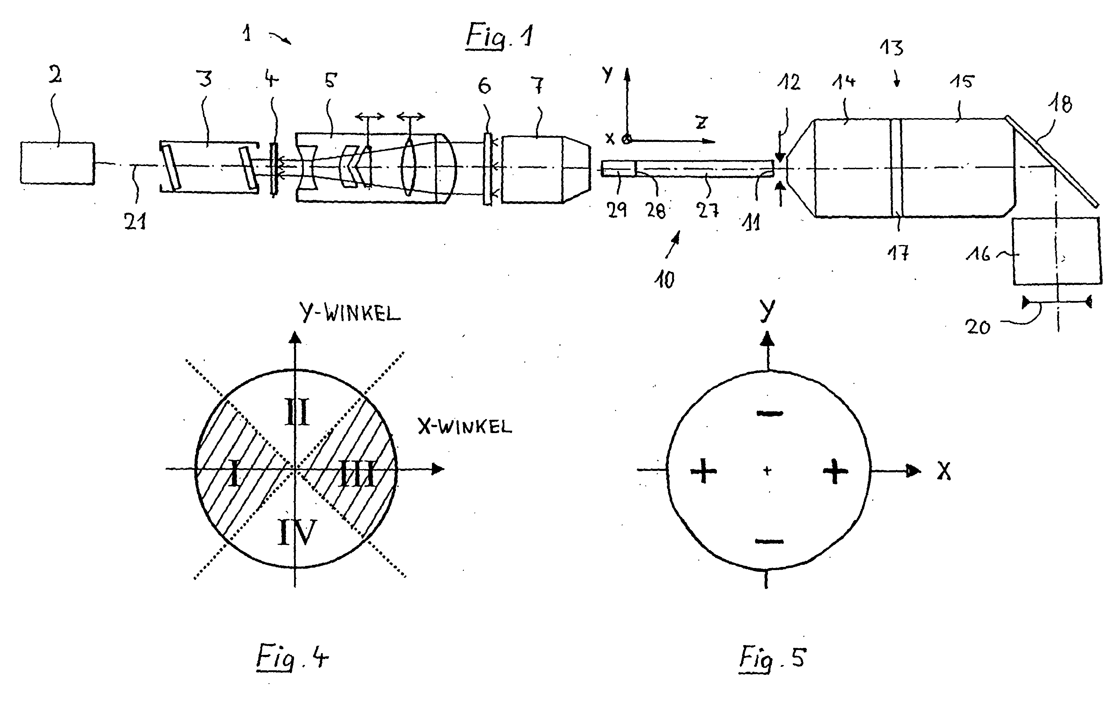

In Fig. 1 ist ein Beispiel einer erfindungsgemäßen Beleuchtungseinrichtung 1 gezeigt, die zum Einbau in eine Projektionsbelichtungsanlage für die mikrolithographische Herstellung von integrierten Schaltkreisen oder anderen feinstrukturierten Bauelementen bei Auflösungen bis zu Bruchteilen von 1 µm vorgesehen ist. Als Lichtquelle dient ein Laser 2, beispielsweise ein im tiefen Ultraviolettbereich (DUV) gebräuchlicher Excimerlaser mit einer Arbeitswellenlänge von 248 nm, 193 nm oder 157 nm. Ein dem Laser nachgeschalteter Strahlaufweiter 3 dient zur Kohärenzreduktion und Strahlformung auf einen rechtwinkligen Strahlquerschnitt mit einem Aspektverhältnis x/y seiner Seitenlängen von beispielsweise ca. 3:1. Ein erstes diffraktives optisches Rasterelement 4 bildet die Objektebene eines nachfolgenden Zoom-Objektives 5, in dessen Austrittspupille eines zweites optisches Rasterelement 6 vorgesehen ist. Von diesem tritt das Licht in eine Einkoppeloptik 7 ein, welche das Licht in einen optischen Lichtintegrator 10 überträgt. Das Licht wird innerhalb des auch als Lichtmischelement bezeichneten Lichtintegrators durch mehrfache innere Reflexion gemischt und homogenisiert und tritt an der Austrittsfläche 11 des Lichtintegrators weitgehend homogenisiert aus. Unmittelbar an der Austrittsfläche 11 ist eine Zwischenfeldebene, in der ein Retikel-Masking-System (REMA) 12, eine verstellbare Feldblende, angeordnet ist. Das nachfolgende Objektiv 13 mit mehreren Linsengruppen 14, 15, 16, Puppillenebene 17 und Umlenkspiegel 18 bildet die Zwischenfeldebene des Retikel-Masking-Systems auf das Retikel bzw. die Photomaske 20 ab.

Dieses Beleuchtungssystem bildet zusammen mit einem (nicht gezeigten) nachgeschalteten Projektionsobjektiv und einem verstellbaren Wafer-Halter eine Projektionsbelichtungsanlage für die Mikrolithographie von elektronischen Bauteilen, aber auch von optischen diffraktiven Elementen und anderen mikrostrukurierten Teilen. Weitere Details zum Aufbau und zur Funktionsweise sind der DE 195 20 563 A1 entnehmbar, deren Inhalt insoweit durch Bezugnahme zum Inhalt dieser Anmeldung gemacht wird.

Bei einem Wafer-Stepper wird auf dem Retikel 20 die gesamte einem Chip entsprechende strukturierte Fläche, im allgemeinen ein Rechteck mit einem beliebigen Aspektverhältnis zwischen Höhe und Breite von z. B. 1:1 bis 1:2 so gleichmäßig und randscharf wie möglich beleuchtet. Bei einem Wafer-Scanner wird auf dem Retikel 20 ein schmaler Streifen, ein Rechteck mit einem Aspektverhältnis von typischerweise 1:2 bis 1:8 beleuchtet und durch Scannen das gesamte strukturierte Feld eines Chips seriell beleuchtet. Auch hier ist die Beleuchtung extrem gleichmäßig und zumindest in Richtung senkrecht zur Scanrichtung randscharf zu gestalten.

In Ausnahmefällen sind auch andere Formen der beleucheten Fläche auf dem Retikel 20 möglich. Die Öffnung des Retikel-Masking-Systems 12 und die Querschnittsform des Lichtintegrators 10 sind der benötigten Form genau angepaßt. Der stabförmige Lichtintegrator 10 des gezeigten Beispiels hat eine rechteckige Querschnittsfläche mit Kantenlängen von 30,3 mm für die parallel zur x-Richtung verlaufenden Breitseiten und 9,7 mm für die senkrecht dazu in Höherichtung bzw. y-Richtung verlaufenden Schmalseiten. Die in Längsrichtung des Lichtintegrators verlaufende z-Richtung liegt parallel zur optischen Achse 21.

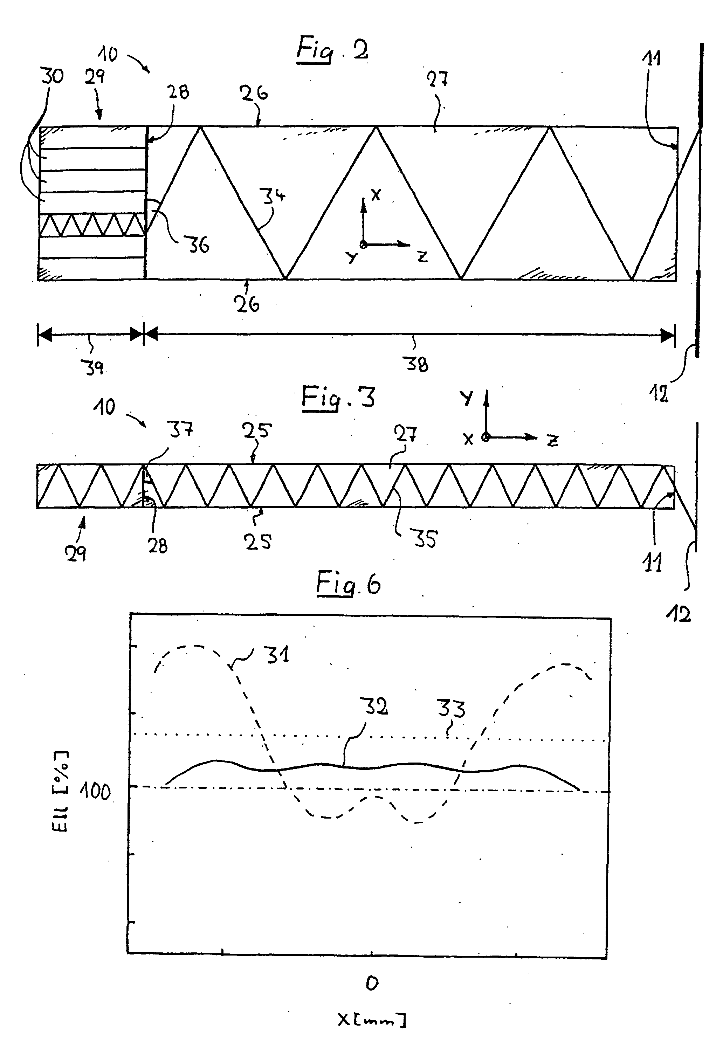

Der Aufbau des stabförmigen Lichtintegrators 10 wird nun an Hand der Figuren 2 und 3 näher erläutert. Dabei zeigt Fig. 2 eine Draufsicht mit Blickrichtung entlang der y-Achse auf eine Breitseite 25 der Integratoroptik und Fig. 3 eine Draufsicht auf eine senkrecht zu den Breitseiten ausgerichtete Schmalseite 26 mit Blick in x-Richtung. Die Integratoroptik 10 besteht im wesentlichen aus einem im Querschnitt rechtekigen Stab 27 aus einem für das Licht der Lichtquelle 2 transparenten Material, beispielsweise aus kristallinem Calziumfluorid, und einer unmittelbar vor der Eintrittsfläche 28 des Stabes angeordneten, gesonderten optischen Baugruppe in Form einer Stabanordnung 29 mit sieben im wesentlichen identischen Stäbchen 30, die aus dem gleichen Material wie der Stab 27 bestehen und jeweils rechtwinklige, identische Querschnitte haben. Dabei entspricht der Gesamtquerschnitt der Stabanordnung 29 dem Querschnitt des Stabes 27, die in y-Richtung gemessenen Höhen der Stäbchen entsprechen der Höhe des Stabes 27 und die in x-Richtung gemessenen Breiten der Stäbchen 30 entsprechen jeweils etwa einem Siebtel der Breite des Stabes 27. Im Beispiel betragen die Kantenlängen des Stabes 27 ca. 30,3 mm in x-Richtung und ca. 9,7 mm in y-Richtung bei einer Gesamtlänge 38 des Stabes 27 von ca. 550 mm. Die Stäbchen sind jeweils ca. 9,7 mm hoch und in x-Richtung ca. 4,3 mm breit und haben eine Länge 39 von ca. 100 mm. Bei der bevorzugten, zur optischen Achse 21 symmetrischen Anordnung einer ungeraden Anzahl von Stäbchen liegt das mittlere Stäbchen auf der optischen Achse.

Zwischen den Stäbchen 30 und der ihnen zugewandten Stirnseite 28 des Stabes 27 besteht ein Abstand von wenigen Zehntel Milimetern, so daß zu mechanischen Beschädigungen führende Berührung vermieden ist. Zwischen den Stäbchen sind (nicht gezeigte) Abstandhalter vorgesehen, die sicherstellen, daß sich die einander zugewandten Breitseiten der Stäbchen 30 nicht berühren, wobei der laterale Abstand mit wenigen Zehntel Milimetern so klein ist, daß im wesentlichen die gesamte Eintrittsfläche 28 flächendeckend durch Stäbchen 30 ausgefüllt ist. Die Abstandhalter können z.B. durch geeignete Folien gebildet sein. Sämtliche ebenen Außenflächen des Stabes 27 und der Stäbchen 30 sind durch geeignete Oberflächenbearbeitung derart geebnet, daß Licht, das in geeignet flachem Winkel auf die Flächen von innen einfällt, mit nur geringen Intensitätsverlusten von beispielsweise 0,5% oder weniger totalreflektiert wird.

Die Lichtverteilung am Ausgang 11 des Lichtintegrators im Bereich des Retikel-Masking-Systems 12 kann durch verschiedene Kenngrößen charakterisiert werden, deren Werte Einfluß auf die Qualität des Belichtungsvorganges haben. Hier werden als wesentliche Größen die Uniformität der Intensitätsverteilung, die Telezentrie und die Elliptizität betrachtet, welche die Lichtverteilung in der REMA-Ebene 12 aufweist. Für die Zwecke dieser Anmeldung gibt die Uniformität die relative Abweichung der Energiedichte von einer konstanten Verteilung über die Bezugsfläche 12 an. Die Idealwerte liegen also nahe beim Wert 0. Unter Telezentrie wird hier der Winkel zwischen dem energetischen Schwerstrahl des abgegebenen Lichtes und der optischen Achse 21 (z-Achse) verstanden. Als Maß für die Elliptizität EII der Pupille wird hier gemäß der Darstellung in Fig. 4 das Verhältnis der Energien verwendet, welche in den um die x-Achse bzw. Breitenrichtung angeordneten Quadranten I + III und den um die y-Achse bzw. Höhenrichtung angeordneten Quadranten II + IV vorhanden ist. Demgemäß wäre bei einer Energieverteilung, bei der in den nahe der x-Achse liegenden Quadranten I und III mehr Energie vorhanden ist als in den nahe der y-Achse liegenden Quadranten II und IV der Wert für die Elliptizität größer als 1 bzw. größer als 100 %. Diese Situation ist in Fig. 5 schematisch dargestellt, wobei die bei der y-Achse liegenden "-"-Symbole eine Lichtintensität unterhalb des Mittelwertes und die im Bereich der x-Achse liegenden "+"-Symbole eine Lichtintensität oberhalb des Mittelwertes symbolisieren.

Eine entsprechende Darstellung der Elliptizität der Pupille in der REMA-Ebene in Abhängigkeit der x-Koordinate in dieser Ebene ist in Fig. 6 gezeigt. Dabei gehört die gestrichelt gezeichnete Kurve 31 zu einem konventionellen, einstückigen Glasstab mit rechtekigem Querschnitt. Die punktierte Linie 33 gibt den Mittelwert von Kurve 31 an. Die auf gesamter Breite unter dem Mittelwert 33 liegende, durchgezogene Linie 32 symbolisiert die Elliptizität am Ausgang eines erfindungsgemäß gestalteten Lichtintegrators. Dies wird im folgenden noch näher erläutert. In Fig. 6 ist an Hand Kurve 31 zu erkennen, daß die Elliptizität im Randbereich der langen Seite den Idealwert von 100 % etwas übersteigt, was dem "+" Symbol in Fig. 3 entspricht. Bei dem gezeigten Beispiel des Standes der Technik ist die Elliptizität im Zentrum der REMA-Ebene 12 geringer als der Idealwert von 100%.

Zur Erläuterung der Funktionsweise des Lichtintegrators 10 zeigen die Fig. 2 und 3 schematisch dargestellte Lichtstrahlen 34, 35, wobei der Lichtstrahl 34 unter einem Winkel 36 in die Integratoroptik eindringt und im wesentlichen parallel zur Breitseite 25 der Optik an den Schmalseiten 26 reflektiert wird, während der Lichtstrahl 35 unter einem Winkel 37 eindringt und an den Breitseiten 25 der Optik mit einer parallel zur y-Achse verlaufenden Reflexionsebene mehrfach total reflektiert wird. Die in Bezug auf die Integratorstirnfläche 33 gemessenen Eindringwinkel 36, 37 sind nicht maßstäblich gezeigt, sondern liegen unterhalb des Grenzwinkels der Totalreflexion des Stabmaterials. Anhand der schematischen Darstellung ist zu erkennen, daß das in der x-z-Ebene reflektierte Licht über die Länge 38 des Stabes nur sechsmal total reflektiert wird, während das in der senkrecht dazu stehenden y-z-Ebene reflektierte Licht (Strahl 35) auf der gleichen Länge viermal häufiger reflektiert wird. Wird davon ausgegangen, daß bei jedem Reflexionsvorgang am Reflexionsort aufgrund von Auskopplung und/oder Absorption ein geringer Bruchteil an Lichtintensität dem total reflektierten Licht entzogen wird, so ist zu erkennen, daß die Totalreflexionsverluste für nahe der y-Achse reflektiertes Licht entsprechend der größeren Anzahl von Reflexionen pro durchstrahlter Länge höher ist als in der dazu senkrecht stehenden x-Richtung. Entsprechend ergibt sich qualitativ bei einem einstückigen Glasstab ohne vorgeschaltete Stabanordnung eine Austrittsintensitätsverteilung im Winkelraum ähnlich der in Fig. 5 gezeigten.

Die hieraus resultierende Asymmetrie bzw. Deformation der Austrittspupille kann durch Vorschaltung der Stabanordnung 29 vor der Eintrittsfläche 28 des Stabes 27 teilweise oder vollständig kompensiert werden, wobei der Grad der Kompensation durch geeignete Wahl von Anzahl und Dimension der Stäbchen variierbar ist. Anhand der Fig. 2 und 3 ist zu erkennen, daß im Bereich der Stabanordnung 29 sich die Verhältnisse zwischen Anzahl der Reflexionen pro Längeneinheit bezogen auf die x- und y-Richtung genau umkehren. Während über die Länge 39 der Stäbchen in x-Richtung (Fig. 2) zehn Reflexionen erfolgen, sind es über die gleiche Länge in y-Richtung (Fig. 3) nur vier Reflexionen. Unter Voraussetzung gleicher Reflexionsverluste pro Reflexion an den Flächen ergibt sich dadurch, daß am Ausgang der Stabanordnung die Totalreflexionsverluste in x-Richtung größer sind als in y-Richtung. Es liegen also - bezogen auf die x- und y-Richtungen - genau umgekehrte Verhältnisse vor wie am Ausgang eines einstückigen Stabes gleicher Querschnittsform. Daher kann durch Vorschaltung einer Stabanordnung 29 der dargestellten Art eine teilweise oder vollständige Kompensation der durch einen einteiligen Glasstab verursachten Deformation der Elliptizität der Austrittspupille erreicht werden.

Der Grad der Kompensation hängt dabei in erster Linie von der Anzahl der Stäbchen, bzw. deren Ausdehnung in x-Richtung und/oder von der Länge der Stäbchen ab. Das Prinzip ermöglicht gegebenenfalls eine vollständige Kompensation wobei jedoch in vielen Fällen eine Teilkompensation ausreichen kann. Im gezeigten Beispielfall kann das Verhältnis der Anzahl der Reflexionen in x- und y-Richtung gegenüber einem ungeteilten Glasstab um etwa 30% reduziert werden.

Die durchgezogene Linie 32 in Fig. 6 verdeutlicht den kompensierenden Effekt über die Breite (in x-Richtung) der REMA-Ebene 12 für das erläuterte Beispiel. Es ist zu erkennen, daß sich der Verlauf der Pupillenelliptizität im wesentlichen in zwei Punkten von dem Verlauf unterscheidet, der sich ohne Kompensationsmittel einstellt. Zum einen ist der Verlauf glatter geworden. Vor allem aber hat sich die Abweichung der Kurve vom Idealwert (100%) gegenüber der unkompensierten Integratoroptik (Kurve 31) vor allem in den Außenbereichen des Stabes deutlich verringert und es treten geringere Maximalabweichungen auf.

Es ist erkennbar, daß durch Bereitstellung erfindungsgemäßer Kompensationsmittel vor dem Lichteintritt in einen einstückigen Glasstab 27 ein erheblicher Anteil der Elliptizität, die Folge der endlichen Reflektivität der Glasstabaußenflächen und unabhängig vom Ort der Stabaustrittsfläche ist, kompensiert werden kann. Daneben zeigt sich, daß durch die als Kompensationseinrichtung dienende Stäbchenanordnung 30 der Feldverlauf der Elliptizität also deren Ortsabhängigkeit am Stabaustritt, in Maßen veränderbar ist, und zwar unabhängig von dessen Ursache. Die bei unkompensierten Glasstäben vorhandene Krümmung des Verlaufs (Kurve 31 in Fig. 6) wird verringert und gegebenenfalls sogar überkompensiert. Dadurch ergibt sich die Möglichkeit, für ein gegebenes Beleuchtungssetting einen Verlauf minimaler Elliptizität einzustellen. Generell können Kompensationsmittel der hier beschriebenen Art auch als Einstellmittel für die energetische Pupillenelliptizität und/oder für den Feldverlauf der Elliptizität angesehen werden, mit deren Hilfe die Elliptizität auf einen gewünschten, gegebenenfalls asymmetrischen Verlauf einstellbar ist. Es hat sich gezeigt, daß weder die Uniformität noch die Telezentrie der Intensitätsverteilung in der REMA-Ebene 12 signifikant verändert werden.

Alternativ oder zusätzlich zu der beschriebenen Anordnung können ein oder mehrere erfindungsgemäße Lichtintegratoren auch an anderer Stelle innerhalb eines Beleuchtungssystemes vorgesehen sein, beispielsweise zwischen Lichtquelle 2 und Zoom-Objektiv 3.

Die obige beispielhafte Darstellung von Zahlenwerten und Trends bezieht sich auf eine Beleuchtung bei einem konventionellen Setting der Beleuchtungseinrichtung mit einem eingestellten Kohärenzgrad σ = 0,26. Hierbei gibt σ das Verhältnis zwischen der bildseitigen numerischen Apertur des Beleuchtungssystems 1 und der objektseitigen numerischen Apertur des nachfolgenden Objektivs an. Während die relative Verbesserungen des Elliptizitätsbeitrages der Reflexionsverluste für verschiedene Beleuchtungssettings ähnlich sind, trifft das für die Kompensation des Feldverlaufes nicht zu. Daher kann es vorteilhaft sein, wenn Einrichtungen vorgesehen sind, die in Abhängigkeit vom Beleuchtungssetting den Aufbau und/oder die Anordnung eines Kompensationsabschnittes derart beeinflussen, daß der gewünschte positive Einfluß auf den Elliptizitätsfeldverlauf erzielt wird.

## Patentansprüche

1. Lichtintegrator für eine Beleuchtungseinrichtung, insbesondere eine Beleuchtungseinrichtung für eine Mikrolithographie-Projektionsbelichtungsanlage, wobei der Lichtintegrator einen Stab (27) aufweist, der aus einem für das Licht einer Lichtquelle (2) transparenten Material besteht, eine der Lichtquelle optisch zugewandte Eintrittsfläche (28) sowie eine gegenüberliegende Austrittsfläche (11) hat und einen im wesentlichen rechteckigen Querschnitt mit einem vom Wert 1 abweichenden Aspektverhältnis zwischen Breite und Höhe aufweist, **dadurch gekennzeichnet, dass** Kompensationsmittel (29) zur Kompensation richtungsabhängiger Totalreflexionsverluste des Stabes (27) vorgesehen sind, wobei dem Stab (27) als Kompensationsmittel mindestens ein im Querschnitt rechteckiger, transparenter Kompensationsabschnitt (29) zugeordnet ist, der so ausgebildet ist, dass Totalreflexionsverluste in Breitenrichtung des Kompensationsabschnitts grösser sind als in der dazu senkrechten kürzeren Höhenrichtung.

2. Lichtintegrator nach Anspruch 1, **dadurch gekennzeichnet, dass** die Kompensationsmittel einen am Eingangsbereich des Lichtintegrators vorgesehenen Kompensationsabschnitt (29) aufweisen, wobei der Kompensationsabschnitt vorzugsweise in Lichtdurchlaufrichtung vor der Eintrittsfläche (28) des Stabes (27) angeordnet ist.

3. Lichtintegrator nach einem der Ansprüche 1 oder 2, **dadurch gekennzeichnet, dass** die Kompensationsmittel mindestens einen Kompensationsabschnitt (29) aufweisen, der durch eine von dem Stab (27) gesonderte optische Baugruppe (29) gebildet ist.

4. Lichtintegrator nach einem der vorhergehenden Ansprüche, **dadurch gekennzeichnet, dass** die Kompensationsmittel mindestens eine Beschichtung und/oder mindestens eine Aufrauhung eines Teilbereiches mindestens einer Seitenfläche des Stabes umfassen, wobei die Beschichtung und/oder Aufrauhung so ausgebildet ist, dass Unterschiede der Totalreflexionsverluste in Breitenrichtung und Höhenrichtung mindestens teilweise kompensiert werden.

5. Lichtintegrator nach einem der vorhergehenden Ansprüche, **dadurch gekennzeichnet, dass** die Kompensationsmittel mindestens eine Einrichtung zur Beaufschlagung mindestens eines Teilbereiches mindestens einer Seitenfläche des Stabes mit einem die Reflektivität des Teilbereiches ändernden Fluid aufweisen, insbesondere durch Umspülung mit einem Gas oder durch Benetzung mit einer Flüssigkeit.

6. Lichtintegrator nach einem der vorhergehenden Ansprüche, **dadurch gekennzeichnet, dass** die Kompensationsmittel mindestens eine vor der Eintrittsfläche (28) des Stabes (27) angeordnete oder anordenbare Stabanordnung (29) aufweisen, die mehrere Stäbchen (30) aus einem für das Licht der Lichtquelle (2) transparentem Material aufweist, wobei vorzugsweise die Stäbchen jeweils einen rechteckigen Querschnitt mit einem zum Aspektverhältnis des Stabes (27) umgekehrten Aspektverhältnis haben.

7. Lichtintegrator nach einem der vorhergehenden Ansprüche, **dadurch gekennzeichnet, dass** der Kompensationsabschnitt, insbesondere die Stabanordnung (29), eine Länge (39) hat, die mehr als 5% der Länge (38) des Stabes (27) beträgt, wobei die Länge (39) des Kompensationsabschnitts (29) vorzugsweise mehr als 10%, insbesondere zwischen ca. 15% und 50% der Länge (38) des Stabes beträgt.

8. Lichtintegrator nach einem der Ansprüche 6 oder 7, **dadurch gekennzeichnet, dass** die Anzahl der Stäbchen (30) grösser als das Aspektverhältnis des Querschnitts des Stabes (27) ist und vorzugsweise im Bereich zwischen drei und zwanzig liegt.

9. Lichtintegrator nach einem der Ansprüche 6 bis 8, **dadurch gekennzeichnet, dass** die Stäbchen durch dünne Platten oder Folien gebildet sind.

10. Lichtintegrator nach einem der vorhergehenden Ansprüche, **dadurch gekennzeichnet, dass** die Kompensationsmittel einen durch eine gesonderte optische Baugruppe (29) gebildeten Kompensationsabschnitt aufweisen, der so angeordnet ist, dass zwischen dem Kompensationsabschnitt und der Eintrittsfläche (28) des Stabes ein Abstand verbleibt, wobei der Abstand vorzugsweise weniger als einen Millimeter, insbesondere zwischen 0,1 mm und 0,5 mm beträgt.

11. Lichtintegrator nach einem der Ansprüche 6 bis 10, **dadurch gekennzeichnet, dass** die Stabanordnung (29) eine dichte Packung von Stäbchen (30) aufweist, die im wesentlichen ohne gegenseitigen Berührungskontakt mit lateralem Abstand zueinander angeordnet sind, wobei der Abstand vorzugsweise weniger als 0,5 mm beträgt und/oder wobei zwischen den Stäbchen Abstandhalter vorgesehen sind.

12. Lichtintegrator nach einem der vorhergehenden Ansprüche, **dadurch gekennzeichnet, dass** der Kompensationsabschnitt, insbesondere die Stabanordnung, in seinem Inneren in Richtung der optischen Achse (z-Achse) gerichtete Flächen aufweist, die derart ausgebildet sind, dass an den Flächen keine Totalreflexion erfolgt, wobei der Reflexionsgrad der Flächen vorzugsweise grösser als ca. 50% ist und insbesondere zwischen ca. 70% und ca. 80% liegt.

13. Lichtintegrator nach einem der vorhergehenden Ansprüche, **dadurch gekennzeichnet, dass** die Kompensationsmittel als Reduzierungsmittel zur Reduzierung des Feldverlaufes der Pupillenelliptizität wirken.

14. Beleuchtungseinrichtung, insbesondere für eine Mikrolithographie-Projektionsbelichtungsanlage, mit einer Lichtquelle (2) und optischen Elementen zur Beeinflussung des Lichtes der Lichtquelle, wobei die optischen Elemente mindestens einen Lichtintegrator (10) umfassen, der einen Stab (27) aufweist, der aus einem für das Licht einer Lichtquelle (2) transparenten Material besteht, eine der Lichtquelle optisch zugewandte Eintrittsfläche (28) sowie eine gegenüberliegende Austrittsfläche (11) hat und einen im wesentlichen rechteckigen Querschnitt mit einem vom Wert 1 abweichenden Aspektverhältnis zwischen Breite und Höhe aufweist, **dadurch gekennzeichnet, dass** Kompensationsmittel (29) zur Kompensation richtungsabhängiger Totalreflexionsverluste des Stabes (27) vorgesehen sind, wobei dem Stab (27) als Kompensationsmittel mindestens ein im Querschnitt rechteckiger, transparenter Kompensationsabschnitt (29) zugeordnet ist, der so ausgebildet ist, dass Totalreflexionsverluste in Breitenrichtung des Kompensationsabschnitts grösser sind als in der dazu senkrechten kürzeren Höhenrichtung.

15. Beleuchtungseinrichtung nach Anspruch 14, **dadurch gekennzeichnet, dass** die Kompensationsmittel mindestens eines der Merkmale des kennzeichnenden Teils von einem der Ansprüche 2 bis 13 aufweisen

16. Mikrolithographie-Projektionsbelichtungsanlage, insbesondere Wafer-Stepper oder Wafer-Scanner, mit einer Beleuchtungseinrichtung und einem Projektionsobjektiv, **dadurch gekennzeichnet, dass** die Beleuchtungseinrichtung gemäss Anspruch 14 oder 15 ausgebildet ist.

## Claims

1. An optical integrator for an iradiation device, in particular, for an irradiation device for a microlithographic projection-exposure system, where the optical integrator has a rod (27) consisting of a material transparent to light from a light source (2), an entrance surface (28) optically facing toward the light source, an exit surface (11) on its opposite end, and an essentially rectangular cross-section having an aspect ratio, i.e., a width-to-height ratio, differing from unity, wherein means (29) for compensating for anisotropic total-reflection losses of the rod (27) are provided, where at least one, transparent, compensation section (29) that has a rectangular cross-section and is configured such that total-reflection losses over the width of the compensation section exceed those over its height, i.e., its shorter dimension, which is orthogonal thereto, is allocated to the rod (27) employed as means for compensating therefor.

2. An optical integrator according to claim 1, wherein the means of compensation are provided with a compensation section (29) in the vicinity of the entrance of the optical integrator, where the compensation section is preferably arranged upstream of the entrance surface (28) of the rod (27), referred to the direction of light transmission.

3. An optical integrator according to claim 1 or claim 2, wherein the means of compensation have at least one compensation section (29) formed from an optical module (29) that is distinct from the rod (27).

4. An optical integrator according to any of the foregoing claims, wherein the means of compensation comprise at least one coating and/or at least one roughening of a portion of at least one lateral surface of the rod, where the coating and/or roughening are configured such that any variations in total-reflection losses over its width and height will be at least partially compensated.

5. An optical integrator according to any of the foregoing claims, wherein the means of compensation have at least one device for supplying at least a portion of at least one lateral surface of the rod with a fluid that will alter the reflectance of that particular portion thereof, in particular, flushing it with a gas or wetting it with a liquid.

6. An optical integrator according to any of the foregoing claims, wherein the means of compensation have at least one arrangement (29) of rods having several rods (30) fabricated from a material transparent to light from the light source (2) arranged, or that may be arranged, in front of the entrance surface (28) of the rod (27), where said rods preferably have a rectangular cross-section with an aspect ratio that is the inverse of that of the rod (27).

7. An optical integrator according to any of the foregoing claims, wherein the compensation section, in particular, the arrangement (29) of rods, has a length (39) exceeding 5 % of the length (38) of the rod (27), where the length (39) of the compensation section (29) is preferably more than 10 %, in particular, is around 15 % to 50 %, of the length (38) of the rod.

8. An optical integrator according to claim 6 or claim 7, wherein the number of rods (30) exceeds the aspect ratio of the cross-section of the rod (27), and preferably falls within the range between three to twenty.

9. An optical integrator according to any of claims 6 - 8, wherein the rods are formed from thin plates or foils.

10. An optical integrator according to any of the foregoing claims, wherein the means of compensation have a compensation section formed from an optical module (29) that is distinct therefrom and arranged such that a vacant space remains between the compensation section and the entrance surface (28) of the rod, where the length of said vacant space is preferably less than one millimeter, in particular between 0.1 mm to 0.5 mm.

11. An optical integrator according to any of claims 6 - 10, wherein the arrangement (29) of rods has a dense pack of rods (30) arranged at a lateral spacing with respect to one another that are such that they essentially do not come into contact one another, where their spacing is preferably less than 0.5 mm, and/or spacers are provided between the rods.

12. An optical integrator according to any of the foregoing claims, wherein the compensation section, in particular, the arrangement of rods, has interior surfaces aligned along the optical axis (z-axis) that are formed such that total reflection will not occur thereon, where the reflectances of said surfaces preferably exceed about 50 % and, in particular, fall within the range extending from around 70 % to around 80 %.

13. An optical integrator according to any of the foregoing claims, wherein the means of compensation act as a means for reducing variations in pupil ellipticity over the entire field.

14. An irradiation device, in particular, an irradiation device for a microlithographic projection-exposure system, having a light source (2) and optical elements for affecting light from the light source, wherein the optical elements comprise at least one optical integrator (10) that has a rod (27) fabricated from a material transparent to light from a light source (2), an entrance surface (28) optically facing toward the light source, an exit surface (11) on its opposite end, and an essentially rectangular cross-section having an aspect ratio, i.e., a width-to-height ratio, differing from unity, wherein means (29) for compensating for anisotropic total-reflection losses of the rod (27) are provided, where at least one, transparent, compensation section (29) that has a rectangular cross-section and is configured such that total-reflection losses over the width of the compensation section exceed those over its height, i.e., its shorter dimension, which is orthogonal thereto, is allocated to the rod (27) employed as means for compensating therefor.

15. An illumination device according to claim 14, wherein the means of compensation have at least one feature of the characterizing portions of any of claims 2 - 13.

16. A microlithographic projection-exposure system, in particular a wafer stepper or wafer scanner, having an irradiation device and a projection objective, wherein the irradiation device is configured according to claim 14 or claim 15.

## Revendications

1. Intégrateur de lumière pour un dispositif d'illumination, en particulier un dispositif d'illumination pour une installation de projection de micro-lithographie, avec l'intégrateur de lumière présentant un bâton (27) composé d'un matériau transparent à la lumière d'une source lumineuse (2), comportant une surface d'entrée (28) faisant face à la source lumineuse, ainsi qu'une surface de sortie (11) située à son autre extrémité et une section généralement carrée d'un rapport d'aspect largeur/hauteur différent de la valeur 1, **caractérisé par le fait que** des moyens de compensation (29) sont prévus pour la compensation des pertes de réflexion totale du bâton (27) en fonction de la direction, avec le bâton (27) comme moyen de compensation auquel est ajoutée au moins une portion de compensation (29) transparente et carrée, conçue de telle façon que les pertes de réflexion totale dans la direction de la largeur de la portion de compensation sont plus élevées que dans la direction de la hauteur, plus courte et perpendiculaire à la direction de la largeur.

2. Intégrateur de lumière selon la revendication 1, **caractérisé par le fait que** les moyens de compensation présentent une portion de compensation (29) prévue dans la zone d'entrée de l'intégrateur de lumière, avec la portion de compensation située de préférence, dans la direction du passage de la lumière, avant la surface d'entrée (28) du bâton (27).

3. Intégrateur de lumière selon l'une des revendications 1 et 2, **caractérisé par le fait que** les moyens de compensation présentent au moins une portion de compensation (29) constituée d'un ensemble optique (29) distinct du bâton (27).

4. Intégrateur de lumière selon l'une des revendications ci-dessus, **caractérisé par le fait que** les moyens de compensation comprennent au moins un revêtement et/ou au moins une rugosité d'une zone partielle d'au moins une surface latérale du bâton, avec le revêtement et/ou la rugosité conçu de façon telle que les différences de perte de réflexion totale entre les directions de la largeur et de la hauteur sont au moins partiellement compensées.

5. Intégrateur de lumière selon l'une des revendications ci-dessus, **caractérisé par le fait que** les moyens de compensation présentent au moins un dispositif d'alimentation d'au moins une zone partielle d'au moins une surface latérale du bâton en un fluide modifiant la réflectivité de cette zone partielle, en particulier par rinçage à l'aide d'un gaz ou par mouillage à l'aide d'un liquide.

6. Intégrateur de lumière selon l'une des revendications ci-dessus, **caractérisé par le fait que** les moyens de compensation présentent au moins un ensemble de bâton (29) installé ou pouvant être installé avant la surface d'entrée (28) du bâton (27) et comportant plusieurs bâtonnets (30) constitués d'un matériau transparent à la lumière de la source lumineuse (2), avec ces bâtonnets de préférence de section carrée et de rapport d'aspect contraire à celui du bâton (27).

7. Intégrateur de lumière selon l'une des revendications ci-dessus, **caractérisé par le fait que** la portion de compensation, en particulier l'ensemble de bâton (29) présente une longueur (39) supérieure à 5% de la longueur (38) du bâton (27), avec la longueur (39) de la portion de compensation (29) de préférence supérieure à 10%, en particulier située entre environ 15% et 50%, de la longueur (38) du bâton.

8. Intégrateur de lumière selon l'une des revendications 6 et 7, **caractérisé par** un nombre de bâtonnets (30) supérieur au rapport d'aspect de la section du bâton (27) et de préférence compris entre trois et vingt.

9. Intégrateur de lumière selon l'une des revendications 6 à 8, **caractérisé par le fait que** les bâtonnets sont constitués de fines plaques ou de feuilles.

10. Intégrateur de lumière selon l'une des revendications ci-dessus, **caractérisé par le fait que** les moyens de compensation présentent une portion de compensation constituée d'un ensemble optique (29) distinct disposé de façon telle qu'il subsiste, entre la portion de compensation et la surface d'entrée (28) du bâton, un interstice de préférence inférieur à un millimètre, en particulier compris entre 0,1 mm et 0,5 mm.

11. Intégrateur de lumière selon l'une des revendications 6 à 10, **caractérisé par le fait que** l'ensemble de bâton (29) présente un faisceau dense de bâtonnets (30) disposés généralement l'un à côté de l'autre mais non contigus en direction latérale, séparés par une distance de préférence inférieure à 0,5 mm et/ou des écarteurs.

12. Intégrateur de lumière selon l'une des revendications ci-dessus, **caractérisé par le fait que** la portion de compensation, en particulier l'ensemble de bâton, présente en son intérieur, dans la direction de l'axe optique (axe z), des surfaces orientées conçues de façon telle que ces surfaces n'offrent pas de réflexion totale, mais un degré de réflexion de préférence supérieur à environ 50% et compris de préférence entre environ 70% et environ 80%.

13. Intégrateur de lumière selon l'une des revendications ci-dessus, **caractérisé par le fait que** les moyens de compensation aient un effet réducteur sur la variation dans le champ de l'ellipticité du diaphragme.

14. Dispositif d'ensemble, en particulier pour une installation de projection de micro-lithographie, comportant une source lumineuse (2) et des éléments optiques destinés à influencer la lumière d'une source lumineuse, dans lequel ces éléments optiques comportent au moins un intégrateur de lumière (10) présentant un bâton (27) composé d'un matériau transparent à la lumière d'une source lumineuse (2), comportant une surface d'entrée (28) faisant face à la source lumineuse, ainsi qu'une surface de sortie (11) située à son autre extrémité et une section généralement carrée d'un rapport d'aspect largeur/hauteur différent de la valeur 1, **caractérisé par le fait que** des moyens de compensation (29) sont prévus pour la compensation des pertes de réflexion totale du bâton (27) en fonction de la direction, avec le bâton (27) comme moyen de compensation auquel est attribué au moins une portion de compensation (29) transparente et carrée, conçue de telle façon que les pertes de réflexion totale dans la direction de la largeur de la portion de compensation sont plus élevées que dans la direction de la hauteur, plus courte et perpendiculaire à la direction de la largeur.

15. Dispositif d'éclairage selon la revendication 14, **caractérisé par le fait que** les moyens de compensation présentent au moins une des caractéristiques de la partie descriptive d'une quelconque des revendications 2 à 13.

16. Installation de projection de micro-lithographie, en particulier "wafer stepper" ou "wafer scanner", avec un dispositif d'illumination et un objectif de projection, **caractérisé par le fait que** le dispositif d'illlumination est conçu selon l'une des revendications 14 et 15.
